# EUROPEAN PATENT APPLICATION

(11) **EP 1 404 147 A2**
(43) Date of publication of application: **31.03.2004**
(21) Application number: 03020892.0
(22) Date of filing: 15.09.2003
(51) Int. Cl.: H04R 3/00, H04M 9/08, H03G 3/34, H04L 1/20

(54) **System for inputting speech, radio receiver and communication system**

(30) Priority: 24.09.2002 JP 2002313459; 24.04.2003 JP 2003153503
(71) Applicant: MARANTZ JAPAN, INC., SAGAMIHARA-SHI, KANAGAWA, 228-8505 (JP)
(72) Inventor: Ohtomo, Masanobu, Sagamihara-shi Kanagawa 229-1123 (JP)
(74) Representative: Patentanwälte Leinweber & Zimmermann

(57) **Abstract**

A system for inputting speech that comprises an echo canceller section (120) for subtracting a pseudo echo signal, generated by an adaptive filter (121) based on a speech signal inputted to a first input terminal (120a), from a speech signal for sending as inputted to a second input terminal (120b) to thereby remove echo components contained in the speech signal for sending; a main microphone (151) for mainly receiving sound from an objective sound source; a reference microphone (152) disposed a predetermined distance apart from the main microphone (151) for mainly receiving sound from other than the objective sound source; and an audio delay section 180 for giving a predetermine delay to the speech signal for sending from the main microphone (151). According to this speech input system, the noise is well removed regardless of directions of the sources of the objective sound and the noise, regardless of the difference in level between the objective sound and the noise and/or regardless of whether the noise abruptly changes its tone or volume, so that a clear speech input is achieved even in such a condition that there is noise in the surrounding environment.
A radio receiver comprising a control section for monitoring an electric field strength and controlling based thereon the operation of a noise canceling means. The noise canceling means may be an audio muting section.

## Description

### BACKGROUD OF THE INVENTION

This invention relates generally to a system for inputting speech and a communication system, and more particularly to such a system for inputting speech and a communication system which are suitable for achieving a clear speech input even under the condition that noise is present in the environment where a communication device for the system is used.

There has been known a technical means called "noise canceller" which is provided, in a speech-input system for use in a communication system, to achieve a clear speech input even under the condition that noise is present in the environment where a communication device for such a system is used.

As representative techniques for such a noise canceller, the following ones (a), (b) and (c) have widely been known:
(a) First and second microphones are arranged in a mutually spaced relation. A difference between a delayed signal of an output of the second microphone and an output of the first microphone is produced at a first adder means, while a difference between the output of the second microphone and a delayed signal of the output of the first microphone is produced at a second adder means. Then, noise components are cancelled by eliminating both of the differences. This technique is described in Japanese Patent Application Laid-Open No. H11-18186.
(b) Japanese Patent Application Laid-Open No. H11-18186 also describes a technique of producing a speech signal obtained by eliminating noise components from an input signal, based on a difference in level between the speech signal and a noise signal which are contained in the input signal to a first microphone.
(c) A first microphone receives a speech signal, while a second microphone receives noise together with the speech signal. A transfer function of the noise contained in the input signal to the second microphone is estimated and pseudo noise components are produced therefrom. The pseudo noise components are subtracted from the input signal to the first microphone to thereby generate a speech signal from which the noise components have been removed. This technique is described in Japanese Patent Application Laid-Open No. H09-36763.

The present invention also relates to a radio receiver for receiving broadcasted or transmitted radio waves and detecting a low-frequency signal therefrom, and in particular to improvements in receiving sensitivity of such receiver in a low electric-field strength condition.

In a radio receiver constructed such that broadcasted or transmitted radio waves are received and a low-frequency signal is detected therefrom, a clear low-frequency signal with suppressed noise is reproduced when the desired radio waves are received in a strong electric-field region.

With such radio receiver, however, when the radio waves are received in a weak electric-field region, noise cannot be suppressed enough as a result of which a low-frequency signal containing noise is reproduced.

Also, when the desired radio waves are not received (in a no-signal condition), only noise is outputted as the low-frequency signal.

In order to avoid the above-described situations, the output of the low-frequency signal is normally blocked by an audio muting section (or a squelch circuit) in a near no-signal condition.

A squelch circuit with such a construction is a very ordinary circuit and is described, for example, in Japanese Patent Application Laid-Open No. 2001-7716 (page 1 and Fig. 4).

There has also been known, apart from the function of the above-described squelch circuit, a technique which utilizes a bandpass filter for limiting a pass band to eliminate noise contained in the low-frequency signal in its lower and higher frequency ranges in a low electric-field strength condition.

The above-mentioned noise canceling techniques (a) to (c) have disadvantages mentioned below in (A) to (C), respectively:
(A) With the above-described technique (a), in a situation that noise originates from a specific direction in the environment and that the objective sound originates only from another specific direction, the objective sound can be received with a good SNR. However, when the noise originates from a direction which is different in angle from the specific direction, when the noise is received from a direction different in angle from the specific direction due to the reflection by an obstacle or when the noise originates from the background in the same direction as the objective sound, the noise cannot be cancelled.
(B) With the aforesaid technique (b), when the received speech signal is substantially different in level from the noise signal, the noise components can be eliminated. However, when there is no substantial difference in level between the speech signal and the noise or when the noise signal is larger than the speech signal, the noise components cannot be removed.
(C) With the aforesaid technique (c), when the pseudo noise components as estimated from the transfer function of the noise contained in the signal received by the second microphone agree with the noise components as received by the first microphone, the noise components can be cancelled. However, when the tone or volume of the noise abruptly changes, the estimated pseudo noise components will not agree with the received noise components, which will bring about another problem that the speech signal after the removal of the pseudo noise components will make somewhat unnatural sounds containing different noise.

### SUMMARY OF THE INVENTION

In view of the above-described problems, it is an object of the present invention to provide a system for inputting speech in which noise can be well removed regardless of directions of sources of the objective sound and the noise, regardless of the difference in level between the objective sound and the noise and/or regardless of whether the noise abruptly changes its tone or volume, and is thus suitable to achieve a clear speech input even in such a condition that there is noise in the surrounding environment.

The inventor of the present invention made an extensive study for solving the above-mentioned problems and found the fact that these problems can be solved by, instead of utilizing the known system incorporating a noise canceller, utilizing an echo canceller not for its original purpose but for the purpose of operating it as a noise canceller.

Simultaneously with the above study, a research was additionally made for a peripheral circuit necessary for having an echo canceller operate as a noise canceller, as a result of which the present invention has been reached.

The present invention as measures for solving the aforesaid problems is constructed as follows:
(1) The invention according to claim 1 is a system for inputting speech that is characterized by comprising an echo canceller section for subtracting a pseudo echo signal, generated by an adaptive filter based on a speech signal inputted to a first input terminal, from a speech signal for sending as inputted to a second input terminal to thereby remove echo components contained in the speech signal for sending; a main microphone for mainly receiving sound from an objective sound source; a reference microphone disposed at a predetermined distance from the main microphone for mainly receiving sound from other than the objective sound source; and an audio delay section for giving a predetermine delay to the speech signal for sending from the main microphone; wherein the speech signal from the reference microphone is inputted to the first input terminal of the echo canceller section, while the speech signal for sending which is from the main microphone and to which the delay has been given in the audio delay section is inputted to the second input terminal of the echo canceller section; and wherein the delay at the audio delay section is adjusted within a range of delay time in which the echo components can be removed by the echo canceller section.
   According to the invention of the above structure, sound from the objective sound source is mainly received by the main microphone, sound from other than the objective sound source is mainly received by the reference microphone, the speech signal from the reference microphone is inputted to the first input terminal of the echo canceller section, the speech signal for sending from the main microphone to which the delay has been given by the audio delay section is inputted to the second input terminal of the echo canceller section, and the delay at the audio delay section is adjusted within the range of delay time in which the echo components can be removed by the echo canceller section. Therefore, by subtracting a pseudo echo signal, generated by the adaptive filter based on the speech signal inputted to the first input terminal, from the speech signal for sending as inputted to the second input terminal, the sound (noise in this case) coming from other than the objective sound source and contained in the speech signal for sending is processed in the same manner as the echo components and is thus removed.
   As a result, the noise is well removed regardless of directions of the sources of the objective sound and the noise, regardless of the difference in level between the objective sound and the noise and/or regardless of whether the noise abruptly changes its tone or volume, so that it becomes possible to achieve a clear speech input even in such a condition that there is noise in the surrounding environment.
(2) The invention according to claim 2 is a system for inputting speech that is characterized by comprising an echo canceller section for subtracting a pseudo echo signal, generated by an adaptive filter based on a speech signal inputted to a first input terminal, from a speech signal for sending as inputted to a second input terminal to thereby remove echo components contained in the speech signal for sending; a main microphone for mainly receiving sound from an objective sound source; a reference microphone disposed at a predetermined distance from the main microphone for mainly receiving sound from other than the objective sound source; an audio delay section for giving a predetermine delay to the speech signal for sending from the main microphone; an interface for receiving a reception signal from an external system and for sending the speech signal for sending which has been processed by the echo canceller section to the external system; and a speaker for outputting the reception signal obtained through the interface as audio; wherein the speech signal from the reference microphone is inputted to the first input terminal of the echo canceller section, while the speech signal for sending which is from the main microphone and to which the delay has been given in the audio delay section is inputted to the second input terminal of the echo canceller section; and wherein the delay at the audio delay section is adjusted within a range of delay time in which the echo components can be removed by the echo canceller section.
   According to the invention of the above structure, sound from the objective sound source is mainly received by the main microphone, sound from other than the objective sound source is mainly received by the reference microphone, the speech signal from the reference microphone is inputted to the first input terminal of the echo canceller section, the speech signal for sending from the main microphone to which the delay has been given by the audio delay section is inputted to the second input terminal of the echo canceller section, and the delay at the audio delay section is adjusted within the range of delay time in which the echo components can be removed by the echo canceller section. Therefore, by subtracting the pseudo echo signal, generated by the adaptive filter based on the speech signal inputted to the first input terminal, from the speech signal for sending as inputted to the second input terminal, the sound (noise in this case) coming from other than the objective sound source and contained in the speech signal for sending and/or the sound (howling sound in this case) from the speaker are processed in the same manner as the echo components and are thus removed.
   As a result, the noise is well removed regardless of directions of the sources of the objective sound and the noise, regardless of the difference in level between the objective sound and the noise and/or regardless of whether the noise abruptly changes its tone or volume, so that it becomes possible to achieve a clear speech input even in such a condition that there is noise and/or sound from a speaker in the surrounding environment.
(3) The invention claimed in claim 3 is a system for inputting speech according to claim 1 or claim 2 which is characterized in that each of the main microphone and the reference microphone is constructed so as to collect sound in a desired manner with the aid of a respective shielding member.
   In this invention having the above-described arrangement, the main microphone in the speech input system described in (1) or (2) above is thus constructed so as to block sound other than the objective sound with the corresponding shielding member to thereby collect sound from the objective sound source more effectively, while the reference microphone is constructed so as to collect sound from other than the objective sound source more effectively.
   As a result, in the system described in (1) or (2) above, the noise is well removed regardless of directions of the sources of the objective sound and the noise, regardless of the difference in level between the objective sound and the noise and/or regardless of whether the noise abruptly changes in its tone or volume, so that it becomes possible to achieve a clear speech input even in such a condition that there is noise and/or sound from a speaker in the surrounding environment.
(4) The invention claimed in claim 4 is a system for inputting speech according to claim 1 or claim 2 which is characterized in that each of the main microphone and the reference microphone is constructed so as to collect sound in a desired manner by its directivity.
   In the invention having the above-described arrangement, the main microphone in the speech input system described in (1) or (2) above is thus constructed so as to collect sound mainly from the objective sound source by its directivity, while the reference microphone is constructed so as to collect sound from other than the objective sound source more effectively by its directivity.
   As a result, in the system described in (1) or (2) above, the noise is well removed regardless of directions of the sources of the objective sound and the noise, regardless of the difference in level between the objective sound and the noise and/or regardless of whether the noise abruptly changes its tone or volume, so that it becomes possible to achieve a clear speech input even in such a condition that there is noise and/or sound from a speaker in the surrounding environment.
(5) The invention claimed in claim 5 is a system for inputting speech according to claim 1 or claim 2 which is characterized in that each of the main microphone and the reference microphone is constructed so as to collect sound in a desired manner by means of a combination of the provision of a shielding member and the directivity.
   In the invention having the above-described arrangement, the main microphone in the speech input system described in (1) or (2) above is thus constructed so as to collect sound mainly from the objective sound source by the combination of the corresponding shielding member and its directivity, while the reference microphone is constructed so as to collect sound mainly from other than the objective sound source by the combination of the corresponding shielding member and its directivity.
   As a result, in the system described in (1) or (2) above, the noise is well removed regardless of directions of the sources of the objective sound and the noise, regardless of the difference in level between the objective sound and the noise and/or regardless of whether the noise abruptly changes in its tone or volume, so that it becomes possible to achieve a clear speech input even in such a condition that there is noise and/or sound from a speaker in the surrounding environment.
   For the improvement of the reception sensitivity of a radio receiver in a low electric-field strength condition, a noise canceling technique (in analog system or digital system) is currently available, for example, for collecting voice sound clearly in a noisy environment.
   The noise generated in the above-described radio receiver is not due to environmental noise sound but is white noise which is similar to components of such environmental noise sound and can therefore be reduced by the use of the existing noise canceling technique.
   Thus, it is expected that the reception sensitivity of a radio receiver is improved by applying the existing noise canceling technique to the radio receiver.
   When such a noise canceling technique is simply applied to a radio receiver, however, a better case or a worse case may result as follows:
   The better case means, for example, a case where noise components of the low-frequency signal (voice sound signal) are reduced when the radio waves are received by the radio receiver in a weak electric-field region, leading to an improvement of the reception sensitivity.
   The worse case means, for example, a case where when radio waves are received in a medium or strong electric-field region the low-frequency signal (voice sound signal) is reproduced not in a natural way but as somewhat unnatural sound as a result of having passed a noise canceling circuit or a noise filter, despite the fact that the low-frequency signal (voice sound signal) should originally be reproduced clearly with suppressed noise in such a case.
   In view of the above-described problems, it is another object of the present invention to provide a radio receiver in which noise components contained in the low-frequency signal can be reduced in a low electric-field strength condition, while in a medium or high electric-field strength condition clearness of the low-frequency signal (articulation) is maintained.
   The present invention is constructed as follows to solve the aforesaid problems:
(6) The invention claimed in claim 6 is a radio receiver for receiving broadcasted or transmitted radio waves and detecting a low-frequency signal therefrom that is characterized by comprising a receiving section for receiving the broadcasted or transmitted radio waves; a detection/demodulation section for subjecting a high-frequency signal generated in response to the reception at the receiving section to a detection operation to produce the low-frequency signal; a noise canceling means for reducing noise components of the low-frequency signal produced by the detection/demodulation section; and a control section for monitoring an electric-field strength of the received radio wave and controlling based thereon the operation of the noise canceling means; wherein the control section brings the noise canceling means into an operating state when the electric-field strength of the received radio wave is low.
   In the radio receiver of the above structure, when the electric field strength of the received radio wave is low, the control section operates and brings the noise canceling means for reducing noise of the low-frequency signal into the operating state. Therefore, the noise components of the low-frequency signal can be reduced by the operation of the noise canceling means in a low electric-field strength condition.
   Also, with the radio receiver of the above structure, in a medium and a high electric-field strength condition the noise canceling means is in a non-operating state in substance, so that the clearness of the low-frequency signal (voice sound) will not be worsened.
   Thus, it will become possible to improve the reception sensitivity of a radio receiver by the reduction of noise components of the low-frequency signal in a low electric-field strength condition, and at the same time it becomes possible to realize a radio receiver in which the clearness will not be worsened for the low-frequency signal in a medium and a high electric-field strength condition.
(7) A radio receiver according to claim 7 is characterized by comprising, in addition to the structure mentioned in (6) above, an audio muting section for blocking an output of the low-frequency signal, wherein the control section brings the noise canceling means into the operating state when the electric-field strength reaches a first level and blocks the output of the low-frequency signal by the audio muting section when the electric-field strength further reaches a second level which is lower than the first level.
   In the radio receiver of the above-described structure, the control section operates such that the noise canceling means is brought into the operating state when the electric-field strength reaches the first level and that the output of the low-frequency signal is blocked by the audio muting section when the electric-field strength reaches the second level lower than the first level.
   More specifically, when the reception of radio waves is made in a medium or a high electric-field strength condition the clearness will not be worsened for the low-frequency signal since the noise canceling means is practically in the non-operating state. In a low electric-field strength condition, the noise canceling mean is in the operating state, so that noise components of the low-frequency signal are reduced. In a further lower electric-field strength condition, the output of the low-frequency signal is blocked by the audio muting section.
   Thus, it will become possible to improve the reception sensitivity of a radio receiver by the reduction of noise components of the low-frequency signal in a low electric-field strength condition, and it further becomes possible to realize a radio receiver in which the clearness will not be worsened for the low-frequency signal in a medium and a high electric-field strength condition.
(8) A radio receiver according to claim 8 is characterized in that, in addition to the structure mentioned in (6) or (7) above being provided, the noise canceling means is capable of switching the amount of reduction of noise (the degree of canceling noise) in a plurality of steps, and in that the control section controls the switching in such a manner that the amount of reduction of noise is increased as the electric-field strength of the received radio waves becomes lower.
   In the radio receiver of the above-described structure, the control section operates such that in the case where the noise canceling means is selectively brought into the operating state to reduce noise components of the low-frequency signal when the electric-field strength of the received radio waves is low, the amount of reduction of noise is increased as the electric-field strength becomes lower. Therefore, it becomes possible to reduce the noise components more effectively as the electric-field strength becomes lower, while maintaining the clearness of the low-frequency signal in a medium and a high field strength condition.
   Consequently, it will become possible to improve the reception sensitivity of a radio receiver by the reduction of noise components of the low-frequency signal in a low electric-field strength condition, and it further becomes possible to realize a radio receiver in which the clearness will not be worsened for the low-frequency signal in a medium and a high electric-field strength condition.
(9) A radio receiver according to claim 9 is characterized in that, in addition to the structure mentioned in (6), (7) or (8) above being provided, the noise canceling means is a bandpass filter for allowing a predetermined band of frequency components of the low-frequency signal to pass.
   In the radio receiver of the above-described structure, the control section operates such that when the electric-field strength of the received radio wave is low the bandpass filter for allowing a predetermined band of frequency components of the low-frequency signal to pass is selected and brought into an operating state. Therefore, in the case of a low electric-field strength condition noise components of the low-frequency signal are eliminated by means of the function of the bandpass filter, while in a medium or a high electric-field strength condition the bandpass filter is practically in a non-operative condition, so that clearness will not be reduced for the low frequency signal.
   Thus, it becomes possible to improve the distortion factor of the low-frequency signal around its central frequency to thereby increase the reception sensitivity of the radio receiver.
(10) A radio receiver according to claim 10 is characterized in that, in addition to the structure mentioned in (9) above being provided, the bandpass filter is capable of switching its frequency band for passing the low-frequency signal in a plurality of steps, wherein the control section performs such a switching operation that the frequency band is made narrower as the electric-field strength of the received radio waves decreases.
   In the radio receiver of the above-described structure, the control section operates such that; when the electric-field strength of the received radio wave is low, the bandpass filter for passing the low-frequency signal within the predetermined frequency band is selected to be put into an operating state to thereby remove the noise components of the low-frequency signal, wherein the pass frequency band of the bandpass filter is made narrower as the electric-field strength becomes lower. It thus becomes possible to remove the noise components more effectively as the electric-field strength becomes lower without reducing the clearness of the low-frequency signal in a medium and a high electric-field strength condition.
   Consequently, it will be possible to improve the distortion factor of the low-frequency signal to thereby increase the reception sensitivity of the radio receiver in a low electric-field strength condition.
   In view of the problems mentioned earlier in this specification, it is a further object of the present invention to provide a communication system in which noise can be well removed regardless of directions of the sources of the objective sound and the noise, regardless of the difference in level between the objective sound and the noise and/or regardless of whether the noise abruptly changes its tone or volume, which is suitable to achieve a clear speech input even in such a condition that there is noise in the surrounding environment, and which can reduce noise components of the low-frequency signal in a low electric-field strength condition while maintaining the clearness of the low-frequency signal in a medium and a high electric-field strength condition.
(11) The invention according to claim 11 is a communication system for carrying out communication with or without wire characterized in that, for a speech input in at least one of the ends of the system between which communication is carried out the speech input system according to any one of claims 1 to 5 is used.
   In this communication system for carrying out communication with or without wire according to the invention of the above-described construction, for the speech input carried out in at least one of the ends between which transmission is made, the speech input system according to any one of claims 1 to 5 is used.
   Consequently, in a communication system for carrying out communication with or without wire, it becomes possible to well remove noise regardless of directions of the sources of the objective sound and the noise, regardless of the difference in level between the objective sound and the noise and/or regardless of whether the noise abruptly changes its tone or volume, and to achieve a clear speech input even in such a condition that there is noise and/or sound from a speaker in the surrounding environment.
(12) The invention according to claim 12 is a communication system for carrying out communication wirelessly characterized in that, for a speech input in at least one of its ends between which communication is carried out, a speech input system according to any one of claims 1 to 5 is used and in that, for at least one of the ends of the system between which communication is carried out, a radio receiver according to any one of claims 6 to 10 is used.

With this communication system for carrying out communication wirelessly, it becomes possible to well remove noise regardless of directions of the sources of the objective sound and the noise, regardless of the difference in level between the objective sound and the noise and/or regardless of whether the noise abruptly changes in its tone or volume, and to achieve a clear speech input even in such a condition that there is noise and/or sounds from a speaker in the surrounding environment.

Furthermore, in this system, when the electric field strength of the received radio wave is low, the control section operates and brings the noise canceling means for reducing noise in the low-frequency signal into an operating state. Therefore, the noise components of the low-frequency signal can be reduced by the operation of the noise canceling means in a low electric-field strength condition.

Also, in the radio receiver of the above structure, in a medium and a high electric-field strength condition the noise canceling means is practically in a non-operating state, so that the clearness of the low-frequency signal (speech) will not be worsened.

Thus, it will become possible to improve the reception sensitivity of the radio receiver by the reduction of noise components of the low-frequency signal in a low electric-field strength condition, and the clearness will not be worsened for the low-frequency signal in a medium and a high electric-field strength condition.

### BRIEF DESCRIPTION OF THE DRAWINGS

Fig.1 is a functional block diagram of a speech input system according to a first embodiment of the invention;
Fig. 2 is a block diagram for explaining the original manner of use of an echo canceller section which is a principal constituent part of the speech input system according to the first embodiment of the invention;
Fig. 3 is a functional block diagram of a speech input system according to a modification of the first embodiment of the invention;
Fig. 4 is a functional block diagram of a radio receiver according to a second embodiment of the invention;
Fig. 5 is a graph showing the characteristics of the bandpass filter in the radio receiver according to the second embodiment of the invention;
Fig. 6 is a graph showing the characteristics of the receiving operation in the radio receiver according to the second embodiment of the invention;
Fig. 7 is a flowchart explaining the operation of the radio receiver according to the second embodiment of the invention;
Fig. 8 is a graph showing the characteristic of the reception sensitivity of the radio receiver according to the second embodiment of the invention as obtained by the operation of the noise canceling means;
Fig. 9 is a graph showing the characteristic of the reception sensitivity of the radio receiver according to the second embodiment of the invention as obtained by the operation of the bandpass filter
Fig. 10 is a graph showing the relation between the gain and the frequency at the bandpass filter in a modification of the second embodiment of the invention; and
Fig. 11 is a graph showing the relation between the gain and the frequency in the radio receiver according to the modification of the second embodiment of the invention when the bandpass filter is in operation.

### DESCRIPTION OF THE PREFERRED EMBODIMENTS OF THE INVENTION

A system for inputting speech and a communication system according to embodiments of the invention will now be described in detail with reference to the accompanying drawings. It is noted, however, that the present invention should not be limited to the specific embodiments as described herein. In the following, description will be made of a specific example of the communication system in which wireless communication is used.

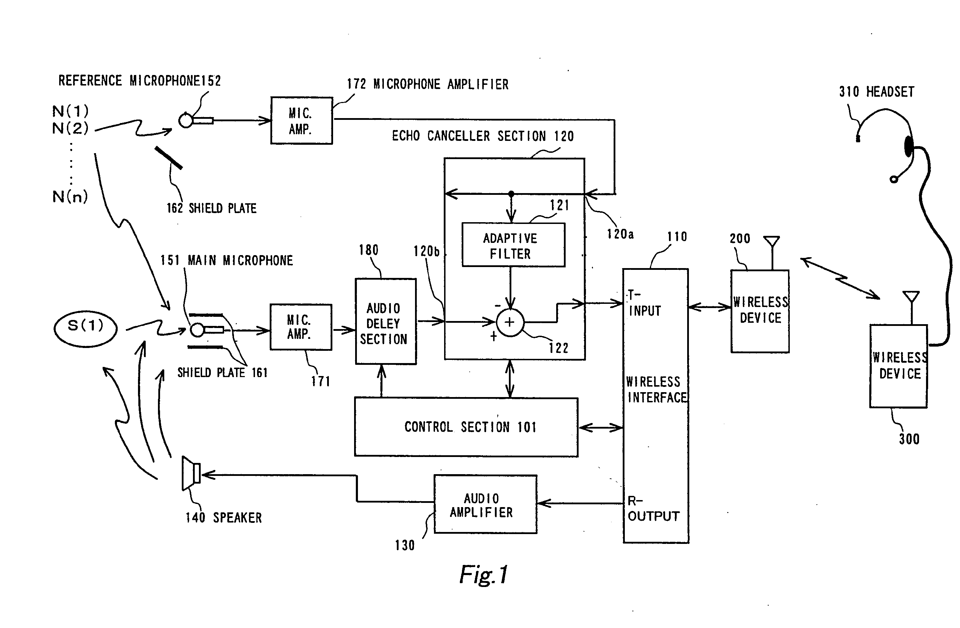

Fig. 1 is a functional block diagram showing the electrical structure of a first embodiment of the invention.

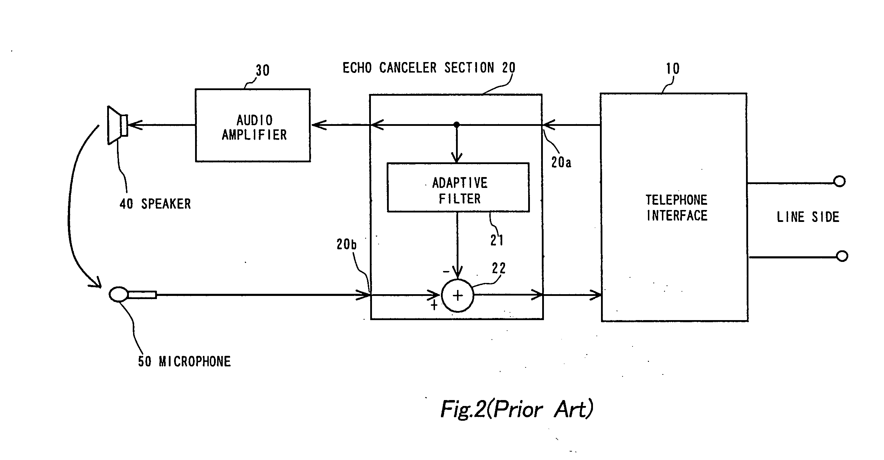

Fig. 2 is a block diagram for explaining the original manner of use of an echo canceller section which is a principal constituent part of the speech input system according to the first embodiment of the invention.

First, a system in which the echo canceller is used for its original purpose is described with reference to Fig. 2.

Shown at 10 is a telephone interface which is connected on its line side (right-hand side in the figure) to a telephone line of the wired system or a wireless telephone line and is connected on the other side to a microphone and a speaker through an echo canceller section.

Shown at 20 is the echo canceller section which serves to eliminate echo components contained in a speech signal for sending.

The echo canceller section 20 eliminates the echo components contained in the speech signal for sending received from the microphone by subtracting, at a subtracter 22, a signal which is generated by an adaptive filter 21 based on a speech signal received at a first input terminal (reception input terminal) 20a and corresponds to a pseudo echo signal in the present invention from the speech signal for sending received at a second input terminal (transmission input terminal) 20b.

Shown at 30 is an audio amplifier for amplifying the speech signal for reception, 40 a speaker for electro-acoustically converting the speech signal as amplified by the audio amplifier 30 to output it as a speech sound, and 50 a microphone provided for acousto-electrically converting sounds (a speech for sending by a speaker) from an objective sound source.

The microphone 50 performs the acousto-electric conversion not only for the sounds from the objective sound source but also for the speech sound for reception coming from the speaker 40 through various reflection paths.

With the above-described structure, the speech signal for reception from the line side passes through the echo canceller section 20 and is amplified by the audio amplifier 30, whereafter it is electro-acoustically converted by the speaker 40 and outputted as a speech sound (speech for reception).

When the speaker 40 and the microphone 50 are disposed in a relatively closely spaced relation to each other, the microphone 50 may pickup speech sounds from the speaker 40 (howling).

The microphone 50 acousto-electrically converts sounds from the objective sound source (i.e., the speech sound for sending) together with the speech sound for reception outputted from the speaker 40 to generate a speech signal for sending.

From this speech signal for sending, the signal generated from the speech signal for reception and corresponding to the pseudo echo signal in the present invention is subtracted at the subtracter 22 of the echo canceller section 20, yielding a signal from which the echo components have been removed.

The speech signal for sending from which the echo components have thus been removed is sent through the telephone interface 10 to the line side.

The echo canceller section 20 described above is used exclusively for the purpose of eliminating echo components in such a case that the speech signal for reception outputted from the speaker 40 gets into the microphone 50 through reflection paths and produce such echo components.

Therefore, the echo canceller section 20 is constructed, taking into consideration the delay time of the echo components getting around from the speaker 40 into the microphone 50, so that the signal corresponding to the pseudo echo signal in the present invention is generated in the adaptive filter 21 within such delay time.

Description will now be made of the speech input system and the communication system according the present embodiments of the invention with reference to Fig. 1.

Shown at 101 is a control section for controlling the entire system which, for example, adjusts the delay time in an audio delay section which will be described later; carries out a control of various levels, a timing control and other controls for an echo canceller section (described later in detail); and carries out a control of various levels and an output control of alarm sound or the like with respect to a wireless interface.

Shown at 110 is a wireless interface which is controlled by the control section 101.

The wireless interface 110 is connected on its line side (right-hand side in the figure) to a wireless device and is connected on the other side through an echo canceller section to a microphone and through an audio amplifier to a speaker.

The wireless interface 110 also carries out a correction of the frequency characteristics of a transmission signal and a reception signal.

Shown at 120 is an echo canceller section for eliminating echo components contained in a speech signal for sending and has a circuit structure which is comparable with that of the echo canceller section 20 shown in Fig. 2.

In the echo canceller section 120, in order to eliminate echo components contained in a speech signal for sending received from a microphone, a pseudo echo signal which an adaptive filter 121 generates based on a speech signal received at a first input terminal 120a is subtracted at a subtracter 122 from the speech signal for sending received at a second input terminal 120b.

A commercially available echo canceller LSI can be used for the echo canceller section 120, but a speech signal from a reference microphone, which will be described later, is supplied to the first input terminal 120a differently from the normal way of use (connection).

Shown at 130 is an audio amplifier for amplifying a speech signal for reception obtained from a wireless device through the wireless interface 110, and shown at 140 is a speaker for electro-acoustically converting the speech signal amplified by the audio amplifier 130 to output it as a speech.

Shown at 151 is a main microphone which is provided for acousto-electrically converting sound S(1) from the objective sound source (i.e., a speech for sending by a speaker) in the main.

The main microphone 151 is constructed so as to collect sounds principally from the objective sound source by any one of the microphone's own directivity and the intervention of a shielding member 161 or by the combination of the two.

The microphone 151 acousto-electrically converts not only the sound S(1) from the objective sound source but also noise sounds N(1) to N(n) from the environment and the speech sound for reception coming from the speaker 140 through various reflection paths.

Shown at 152 is a reference microphone.

The reference microphone 152 is provided at a position which is a predetermined distance spaced from the main microphone 151 and carries out sound collection in such a manner that sounds from other than the objective sound source (mainly, noise sounds N(1) to N(n) from the environment) are mainly picked up while excluding sound S(1) from the objective sound source as much as possible.

The reference microphone 152 is constructed so as to mainly collect noise sounds from the environment by any one of its own directivity and the intervention of a shielding member 162 or by a combination of the two.

Shown at 171 is a microphone amplifier for amplifying a speech signal for sending received from the main microphone 151 to a predetermined level, and shown at 172 is another microphone amplifier for amplifying a speech signal received from the reference microphone 152 to a predetermined level.

The speech signal originating from the reference microphone 152 and amplified by the microphone amplifier 172 is supplied to the first input terminal 120a of the echo canceller section 120.

Shown at 180 is an audio delay section for giving a desired delay time to the speech signal for sending received from the main microphone 151. The speech signal for sending from the main microphone which has thus been delayed by the audio delay section 180 is supplied to the second input terminal 120b of the echo canceller section 120.

In the above-described construction, the control section 101 performs such a control that the delay time at the audio delay section 180 is adjusted within (or included in) the range of delay time of echo components which can be removed by the echo canceller section 120.

Shown at 200 is a communication device in the form of a wireless device which constitutes one end of the present communication system. In this case, the wireless device 200 is connected through the wireless interface 110 to the speech input system according to the present embodiment of the invention.

Shown at 300 is another wireless device which constitutes the other end of the present communication system. The wireless device 300 is not connected to a speech input system according to the present embodiment but allows a speaker to have a wireless communication via a headset 310.

Description will now be given on a specific case where the speech input and communication systems according to the embodiments of the invention are arranged for receiving orders at a drive through of a fast food store.

In the above-described construction, the main microphone 151 is installed so as to pick up the voice of a customer (the sound S(1) from the objective sound source; hereinafter referred to as "objective sound") who has come to the drive through.

The reference microphone 152 is installed so as to pick up noises coming from the environment such as the engine noise (N(1)) and the sound of the cooling fan of the radiator (N(2)) of the car of a customer who has reached the drive-through order window, and the running noise of the vehicles traveling on a near-by road.

At such drive through where the speech input and communication systems of the above type have been installed, it is desirable that the customer coming to the drive-through order window maneuvers his/her car so as to approach just in front of the main microphone 151, i.e., so as to stop the car at a closely approached position, when he/she places an order without getting off the car.

However, it is not always true that all the customers stop their cars at such a closely approached position. Consequently, it may happen that a distance on the order of 1m or more is present between the customer sitting on the driver's sheet of the car and the main microphone 151.

In such a case, the main microphone 151 picks up not only the objective sound but also various noises coming from the environment such as the engine noise (N(1)) and the sound of the cooling fan of the radiator (N(2)) of the car of the customer who has come to the drive through, and the running noise of the vehicles traveling on a near-by road.

It is therefore desirable that the shielding member 161 is arranged so that such various noises from the environment hardly get into the main microphone 151.

Although the shielding member 161 can take the form of a plate as an example, it will be desirable, taking into consideration of the sound shielding effect, to select a tubular shape adaptively to the situation where it is used.

On the other hand, it is desirable that the shielding member 162 is arranged near the reference microphone 152 and perpendicularly to the line connecting the reference microphone 152 to the mouth of the customer so that the voice (S(1)) of the customer who has come to the drive-through order window does not get into the reference microphone 152, i.e., only the voice (S(1)) of the customer is shielded.

Although the shielding member 162 can take the form of a plate or a tube as its examples similarly to the shielding member 161, it will be desirable, taking into consideration of the sound shielding effect, to select an appropriate shape adaptively to the situation where it is used.

It is also desirable to select the distance between the reference microphone 152 and the main microphone 151 to be 1.5m at maximum.

With such arrangement, the maximum difference in arrival time of noise between the time when particular noise arrives first at the main microphone 151 and the time when the same noise arrives at the reference microphone 152 will be equal to 1.5/340 ≅ 0.0044 sec (= 4.4 ms) when the sound velocity is assumed to be 340 m/sec.

The echo canceller IC which the inventor used for the experimentation of the echo canceller section 120 according to this embodiment has an allowable time for echo cancellation in the range from 1 ms to 59 ms.

Therefore, in order to cancel noise with the echo canceller IC used, 4.4. + 1 = 5.4 ms or more will be needed. It is thus necessary to delay the signal representing the objective sound and the noise as picked up by the main microphone 151 by an amount in the range from 5.4 ms to 59 ms.

Consequently, the audio delay section 180 should have the audio reproducing characteristics of low noise and distortion and the capability of adjusting its audio delay time to a value equal to or greater than 5.4 ms.

In the above-described experiment of this embodiment, the speech delay time at the audio delay section 180 was set to 20 ms under the control of the control section 101.

In the meantime, it will be preferable to use for the audio delay section 180 a digital audio delay IC which only delays a received signal by a preset time without affecting the content of the signal as much as possible.

Although a received signal, for example, of a mobile telephone is supplied to the input terminal 120a of the echo canceller section 120 in the original way of use thereof, in this embodiment the noises picked up by the reference microphone 152 from the environment (N(1) to N(n)) are supplied to the input terminal 120a, so that these noises picked up by the reference microphone 152 from the environment are processed in the same manner as the received signal of a mobile telephone.

The second input terminal 120b of the echo canceller section 120 receives the voice (S(1)) of the customer who has come to the drive-through order window and the noises (N(1) to N(n)) all picked up by the main microphone 151 as audio signals (S'(1) and N'(1) to N'(n)) which have been delayed by a delay time assigned to the audio delay section 180.

In the echo canceller section 120, the audio signal (the noises from the environment N(1) to N(n)) received at the first input terminal 120a is converted by an A/D converter (not shown) into a reference digital audio signal which is held and updated as information to be applied to the adaptive filter 121.

Also, the audio signal for sending (S'(1) and N'(1) to N'(n)) received at the second input terminal 120b is converted by an A/D converter (not shown) into a digital audio signal for sending.

The digital audio signal for sending is compared with the reference digital audio signal which has previously been held, and it is determined that an echo is present when similar information is contained therein, whereupon the echo is cancelled from the digital audio signal for sending by means of the subtracter 122 while a level correction being given to the adaptive filter 121 which is adaptively updated.

Thereafter, the digital audio signal for sending from which the echo components have been cancelled is reconverted by a D/A converter (not shown) into an analog signal.

By the above-described series of operations, noise canceling is carried out to such extent that the objective sound (S'(1) and N'(1) to N'(n)) picked up by the main microphone 151 and delayed has become only the objective sound (S'(1)) in terms of audibility when outputted from the transmission output terminal of the echo canceller section 120, as a result of which a signal is obtained from which the noises (N'(1) to N'(n)) from the environment have been cancelled.

This objective sound (S'(1)) is supplied to the wireless interface 110 and then sent to the wireless device 200 after subjected to a correction of frequency characteristics and adjusted to the transmission input level of the wireless device 200 as occasion demands.

The objective sound (S'(1)) is modulated on a transmission radio wave at the wireless device 200 and transmitted to the wireless device 300.

The transmission radio wave is received by the wireless device 300 wherein it is demodulated into a speech signal and outputted from a headphone part of the headset 310 as speech sound.

The headset 310 is provided for the purpose that a clerk of a shop provided with such a drive through facility wears it and listens to an order from a customer. In this case, since the headset 310 provides speech sound from which noise sounds (N'(1) to N'(n)) have been cancelled, the clerk only hears the customer's voice (objective sound), so that he/she can perform exchange of information such as receiving an order in a simple manner without fail, with the result that the work efficiency is improved.

A speech spoken by the clerk is picked up by the microphone part of the headset 310 and sent to the wireless device 300. In addition to the fact that the clerk speaks with the headset 310 in a quiet place in the store, the microphone of the headset 310 is positioned in the vicinity of his/her mouth.

Therefore, the spoken speech contains substantially no noise and will make a clear speech sound.

The sound of spoken speech is modulated on a transmission radio wave at the wireless device 300 and transmitted. This transmission radio wave is received by the wireless device 200 wherein it is demodulated into a speech signal and sent to the wireless interface 110.

This speech signal is subjected to a correction of frequency characteristics and/or a level adjustment in the wireless interface 110 and is supplied thence to the audio amplifier 130.

The audio amplifier 130 amplifies the supplied audio signal at a predetermined gain and outputs the same to the speaker 140.

The speaker 140 reproduces the speech sound of the clerk at an appropriate volume level, so that the customer can hear the speech of the clerk clearly.

Although the sound outputted from the speaker 140 is also picked up at the reference microphone 152 and the main microphone 151, it will be cancelled in the same manner as the environmental noise sounds (N(1) to N(n)), so that no echo nor howling will be caused. It is noted here that the speech signal to be outputted from the speaker 140 does not pass through the echo canceller section 120, which is a new feature not present in the representative original way of use of the conventional echo canceller section.

During the above-described operation of the invention, the control section 101 sets the delay time of the audio delay section 180 and carries out controls such as a control of various levels and a timing control for the echo canceller section 120.

Also, the control section 101 performs, among others, a control of various levels, an output control, for example, of an alarm sound and processing of information of various sensors for the wireless interface 110.

Although not shown in the figure, an A/D converter is provided on the input side of the audio delay section 180 and a D/A converter is provided on the output side of the same audio delay section 180.

Furthermore, although not shown in the figure, an A/D converter is provided at the second input terminal 120b of the echo canceller section 120 and a D/A converter is provided on the output side thereof.

If the echo canceller section 120 and the audio delay section 180 are integrated into one, the intermediate D/A and A/D converters can be dispensed with, which is advantageous in terms of cost.

The speech input and communication systems according to the present embodiment are not only applicable to a drive through facility but also to other cases where wireless communications are performed in a noisy working environment such as wireless communications between a crane operator and a crane slinger and wireless communications between a pilot in a cockpit of a jetliner being moved on the ground and a ground worker who moves the jetliner by a tractor.

In these cases, the main microphone may be provided on a headset at its normal microphone position, while the reference microphone may be provided on the headset at any other position (at its headband portion, for example).

The present invention is also applicable to a speech input device for other apparatuses such as telephone terminal, a television conference apparatus and a vehicle navigation apparatus.

As described above, according to the embodiments of the invention an echo canceller is used in a manner different from the conventional way of use to thereby provide novel measures for removing noise, so that noise is well removed regardless of directions of sources of objective sound and noise, with the result that a clear speech input can be achieved even under the circumstances that there is noise in the surrounding environment.

Also, noise can be well removed regardless of the difference in level between the objective sound and the noise sound, so that a clear speech input can be achieved even under the circumstances that there is noise in the surrounding environment.

Furthermore, noise can be well removed even when the noise abruptly changes its volume and/or tone, so that a clear speech input can be achieved even under the circumstances that there is noise in the surrounding environment.

Description will now be made on the results of an experiment carried out in relation to a preferred embodiment of the present invention.

In the speech input system described above, an LSI having a product name "MSM7731-02" of Oki Electric Co., Ltd. developed for the application to a mobile telephone was used for the echo canceller section 120. This LSI was connected, differently from the original way of connection, in accordance the above-described embodiment to construct the circuit.

A digital audio delay IC was used for the audio delay section 180 and the experiment was conducted after setting its audio delay time to 20 ms.

The experiment was conducted using as the noise sound an engine sound of a diesel-engine car which is generated substantially in the same frequency band as a human voice. The main microphone 151 was used as a customer-side microphone for giving an order at the drive-through order window, while the reference microphone 152 was used as a microphone for detecting noise sounds. The headset 131 was worn by a clerk who receives an order at the drive through.

The result was that the engine sound of the car contained in the speech sound after the noise cancellation had been reduced to such extent that it was hardly audible, and only the customer's voice was clearly heard at the headset of the clerk.

It will thus become possible, by virtue of the fact that voice sound from the customer is clear and does not contain any noise sound to such extent that it is audible whereby it will not happen that an order from a customer at a remote noisy place is missed or incorrectly received, to realize a drive through system which has a high operation efficiency, can provide customers with speedy services and will not make customers uncomfortable.

A similar experiment was also conducted with respect to a conventionally known noise canceller. The result was that the speech sound from the customer side contained the engine sound of the diesel-engine car to such extent that it was audible and recognizable, and it was thus confirmed that the voice from the customer side was difficult to hear.

As described above, a clear and significant difference was recognized between the present invention and the prior art.

It will further be possible to obtain a more clear speech input against noise sound by combining the sensitivities of the main microphone 151 and the reference microphone 152 in a variety of ways (for example, using a microphone of high sensitivity as the main microphone 151 and a microphone of normal sensitivity as the reference microphone 152) in addition to the combination of the main microphone 151 with the shielding member 161 and the combination of the reference microphone 152 with the shielding member 162.

Description will now be given as to the case where sound S(1) from the objective sound source and sound from other than the objective sound source (noise sound) are present in the environment of use with the same level, the echo canceller section 120 has such a property that the echo canceling is carried out with respect only to those of the signals supplied to the first input terminal 120a whose signal level exceeds a predetermined level, the echo canceller section 120 can attenuate an echo by its echo canceller by about 20 dB although it may vary depending on the input level, and the predetermined level is set to a level which is 15 dB lower than the level of the sound S(1) from the objective sound source.

In order that the sound S(1) is not cancelled as much as possible, the level of the sound S(1) originating from the objective sound source but picked up by the reference microphone 152 is made 15 dB lower than the level of the sound S(1) originating from the objective sound source and picked up by the main microphone 151, as a result of which the sound will not be cancelled at the echo canceller section 120.

More specific embodiments were implemented to examine the effectiveness of the present invention, but there was a limit in attenuating the sound S(1) from the objective sound source solely with the shielding member 162 on the side of the reference microphone 152 even when the reference microphone 152 and the objective sound source were apart, although the reference microphone 152 was arranged not to pick up the sound S(1) from the objective sound source by the provision of the shielding member 162 in order that the sound S(1) would not be cancelled as much as possible, but since the reference microphone 152 had to pick up sounds (noise sounds) from other than the objective sound source.

A trial for solving the problem was then made as to the case where the level of the sound S(1) from the objective sound source which had been attenuated by the shielding member 162 provided on the side of the reference microphone 152 was only of the order of 10 dB.

Specifically, when the level of the sound S(1) from the objective sound source which had been attenuated by the shielding member 162 on the side of the reference microphone 152 was only of the order of 10 dB, the lack of attenuation would be 5 dB.

Then, a microphone of a normal pick-up sensitivity was used for the reference microphone 152 and a microphone whose sensitivity is 6 dB higher than the pick-up sensitivity of the reference microphone 152 was used for the main microphone 151.

Theoretically, it should have become possible to make the level of the sound S(1) of the objective sound source picked up by the reference microphone 152 16 (=10 + 6) dB lower than the level of the sound S(1) of the objective sound source picked up by the main microphone 151.

The actual value measured with a level meter also indicated a similar result and its feeling of hearing was good.

With the above arrangement, although the level of sound originating from other than the objective sound source and picked up by the main microphone 151 is made 6 dB higher, since the canceling capability of the echo canceller IC used in the present case is of the order of 20 dB, it will be possible to cancel sound of 14 (=20-6) dB from other than the objective sound source.

This means that even in such environment that there are sound S(1) from the objective sound source and sounds (noise sounds) from other than the objective sound source at the same level, the signal inputted to the transmission input terminal of the wireless interface 110 is such a signal in which the level of the sound S(1) of the objective sound source has been maintained and only the sounds from other than the objective sound source (the noise sounds) have been attenuated by 14 dB, and is thus a signal which represents only the sound (S) of the objective sound source in substance.

As described above, it has been revealed that the difference between the sensitivity level of the main microphone 151 and the sensitivity level of the reference microphone 152 contributes to the achievement by the main microphone 151 of a more clear speech input against noise sounds.

The sound S(1), which is the voice of a customer using the drive through, is blocked by the shielding member 162 and is thus difficult to be picked up by the reference microphone 152. However, the position of the mouth of a customer using the drive through changes from customer to customer and may approach the reference microphone 152.

When a customer approaches the reference microphone 152, the voice S(1) of that customer is picked up by the reference microphone 152 although by a small amount. The voice of the customer using the drive through is then cancelled at the echo canceller section 120 accordingly.

Since most of frequency components of a human voice lie below 1500 Hz, when a relatively large noise sound in a frequency range equal to or higher than 1500 Hz gets mixed with such voice, it tends to result in that the voice is difficult to hear at the receiving side.

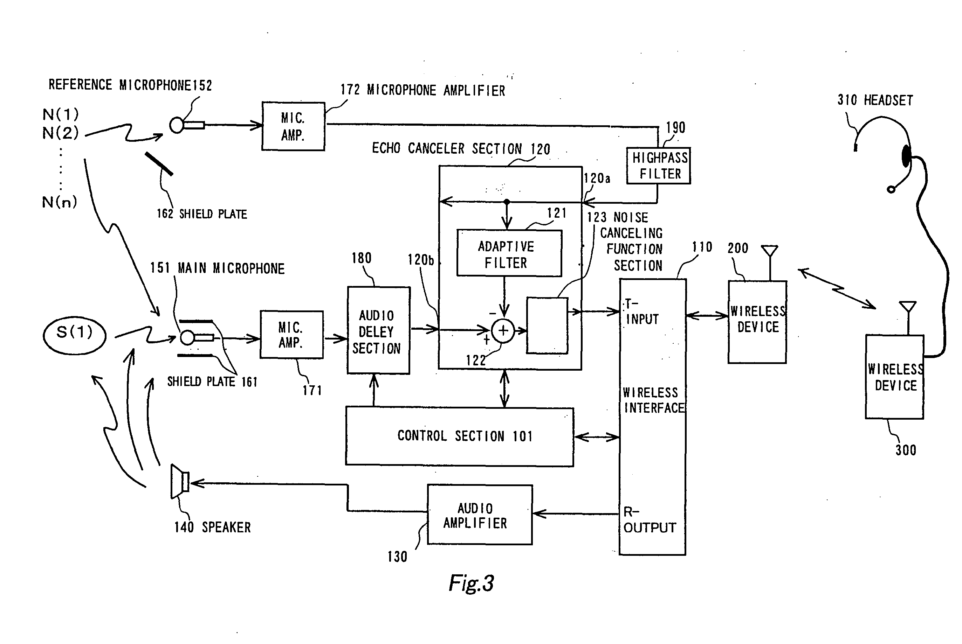

Hence, as shown in the block diagram of Fig. 3, a high-pass filter 190 which allows higher frequency components of the speech signal amplified by the microphone amplifier 172 to pass but blocks the speech signal's frequency components equal to or lower than 1500 Hz is provided on the upstream side of the first input terminal 120a. With this arrangement, it becomes possible to avoid such a situation that the voice of a customer using the drive through is cancelled by the echo canceller section 120.

When constructed as described above, the noise canceling effect will slightly fall with respect to noise sounds in the low frequency rage below 1500 Hz. Then, use is made of a built-in function of the IC used in the present embodiment for the echo canceller section 120 by arranging it as a noise canceling function section 123 on the downstream side of the subtracter 122, whereby an enough noise canceling effect can be maintained also with respect to noise sounds in the low frequency range below 1500 Hz.

By jointly using the built-in noise canceling function section 123 of the noise canceller IC in this manner, it also becomes possible to cancel electrical noises generated in the microphone amplifier 171 and the audio delay section 180, whereby a more effective noise canceller means can be constructed.

As described above in detail, according to the speech input and communication systems of the present invention, noise can be well removed regardless of directions of the sources of the objective sound and the noise, regardless of the difference in level between the objective sound and the noise and/or regardless of whether the noise abruptly changes its tone or volume, so that it is possible to realize a situation which is suitable to achieve a clear speech input even in such a condition that there is noise in the surrounding environment.

A radio receiver and a communication system according to embodiments of the present invention will now be described in detail. It is noted, however, that the present invention should not be restricted to specific examples given in the description of these embodiments. Also, the radio receiver according to the present embodiment may be an independent radio receiver or a radio transceiver constructed by the integration of a ratio transmitter and a radio receiver.

In the following description, as a specific example of the embodiment use is made of a radio transceiver for transmitting/receiving a frequency modulated RF signal to which the present invention has been applied.

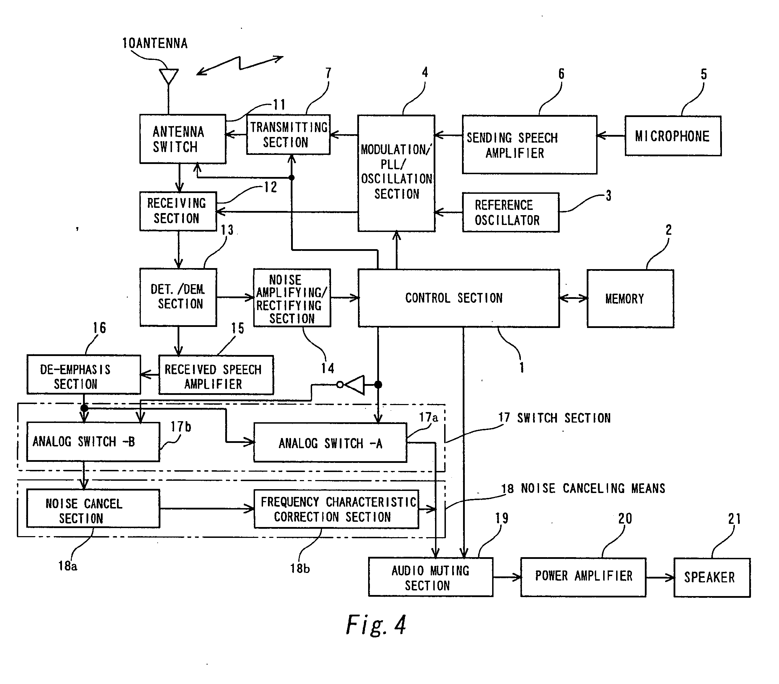

In Fig. 4, shown at 1 is a control section which is a means for controlling various portions of this radio receiver and is constructed, for example, by a microprocessor. Shown at 2 is a memory in which various data necessary for the control by the control section 1 are stored. Shown at 3 is a reference oscillator for supplying a reference frequency signal for use as a reference to signals necessary for transmission and reception.

Shown at 4 is a modulation/PLL/oscillation section which generates signals necessary for transmission and reception based on the reference frequency signal from the reference oscillator 3 and also carries out a modulation operation for transmission.

Shown at 5 is a microphone for converting a speech sound to a low-frequency signal for sending, and shown at 6 is a sending speech amplifier which amplifies the low-frequency signal while emphasizing its higher frequency components for the pre-emphasis prior to transmission.

Shown at 10 is an antenna for transmitting and receiving radio waves, while shown at 11 is an antenna switch for switching the flow of signal with respect to the antenna 10 between transmission and reception. Shown at 12 is a receiving section for receiving a radio wave signal captured by the antenna 10, while shown at 13 is a detection/demodulation section for subjecting the received signal to an FM detection to demodulate it into a low-frequency signal.

Shown at 14 is a noise amplifying/rectifying section which amplifies and rectifies ultra high-frequency noise components (above 4 kHz, for example) of the low-frequency signal contained in the detection output to generate a voltage corresponding to the amplitude of the ultra high-frequency noise components, the voltage being supplied to the control section 1. Shown at 15 is a received speech amplifier for amplifying the demodulated low-frequency signal to a predetermined level, while shown at 16 is a de-emphasis section for attenuating the higher frequency components of the low-frequency signal which have been emphasized prior to transmission.

Shown at 17 is a switch section for changing over active/non-active state of a noise canceling means 18 in accordance with a noise cancel control signal from the control section 1, wherein 17a designates an analog switch-A for blocking or passing the low-frequency signal from the de-emphasis section 16 in accordance with the noise cancel control signal from the control section 1 while 17b designates an analog switch-B for passing or blocking the low-frequency signal from the de-emphasis section 16 in accordance with an inverted signal of the noise cancel control signal from the control section 1.

Shown at 18 is a noise canceling means for reducing noise components, wherein 18a designates a noise cancel section for reducing predetermined noise components from the low-frequency signal while 18b designates a frequency characteristic correction section for correcting the frequency-to-gain characteristic, for example, emphasized at certain portions thereof by the noise cancel section 18a into flat or easy-to-listen characteristic.

If the circuit can carry out the noise canceling with the frequency-to-gain characteristic being kept flat, the above-mentioned frequency characteristic correction section can be dispensed with. However, if an emphasis or the like of the frequency-to-gain characteristic at a certain portion thereof is caused by the noise canceling, it is desirable to provide the frequency characteristic correction section.

Here, it will be possible to replace the combination of the noise cancel section 18a and the frequency characteristic correction section 18b by a bandpass filter.

A reference numeral 19 designates an audio muting section for blocking or passing the low-frequency signal in accordance with a squelch control signal from the control section 1, while a reference numeral 20 designates a power amplifier for amplifying the low-frequency signal. A reference numeral 21 designates a speaker for outputting the amplified low-frequency signal as a speech sound.

In the meantime, this radio transceiver may be of the single superheterodyne type, the double superheterodyne type, triple superheterodyne type or any other type of circuit structure.

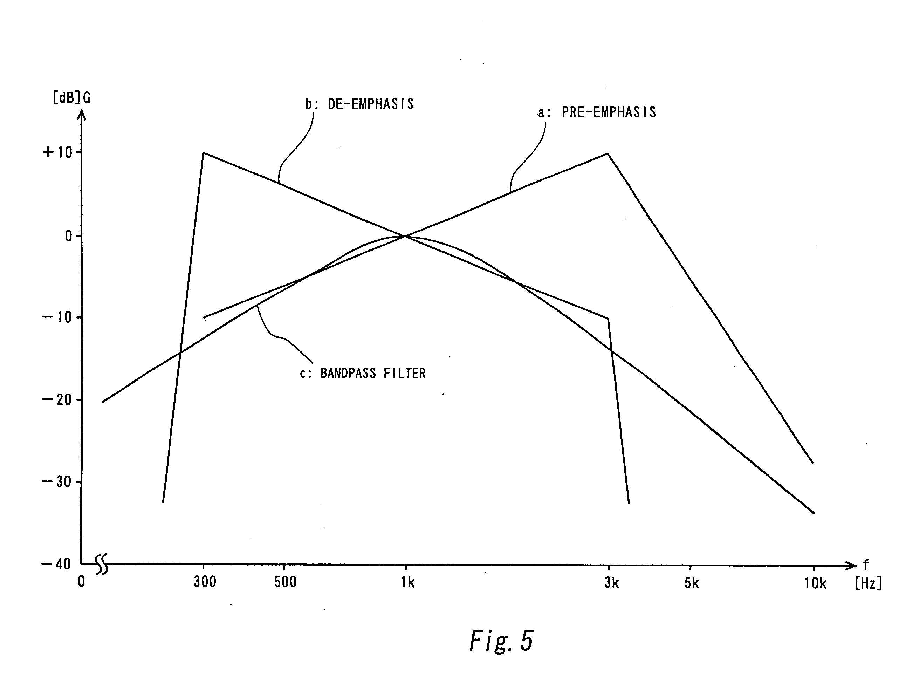

The pre-emphasis characteristic given in the above-described sending speech amplifier 6 prior to transmission is such a characteristic that the higher frequency components in the range from 300 Hz to 3 kHz are emphasized as shown in Fig. 5 at a.

On the other hand, the de-emphasis characteristic given in the above-described de-emphasis section 16 upon reception is such a characteristic that the higher frequency components in the range from 300 Hz to 3 kHz are attenuated as shown in Fig. 5 at b.

Consequently, the higher frequency components of the low frequency signal which have been emphasized by the pre-emphasis operation prior to transmission are attenuated upon reception to resume the flat frequency-to-gain characteristic. Thus, the noises which are liable to occur relatively more on the higher frequency side will be suppressed by the de-emphasis characteristic when received.

The inventor conducted an experiment using, for the noise cancel section 18a, an 1C of type MSM7731-02 (product name of a digital noise canceller) of Oki Electric Co., Ltd. which is a generally commercially available IC.

This digital noise canceller IC is constructed such that three kinds of noise reduction amounts, namely 8dB, 13.5dB and 17dB, can selectively be used. In this case, the clearness of sound after passing through this digital noise canceller IC is best when the noise reduction amount of 8dB is selected, and the clearness tends to slightly drop with the increase in the noise reduction amount.

This noise canceller IC reduces not only white noise, as a matter of course, but also single tones. Therefore, for example, a beep sound to be outputted upon key input should be inputted to the downstream side of the noise cancel section 18a.

This digital noise canceller 1C has been manufacture for the application to a transmitting section and has, accordingly, such characteristics that higher frequency components of the low-frequency signal in the range from 300 Hz to 3 kHz are emphasized when passing through this digital noise canceller IC. Therefore, the higher frequency components of the low-frequency signal are attenuated by the frequency characteristic correction section 18b to resume the flat frequency-to-gain characteristic.

Thus, the higher frequency components of the low-frequency signal which have been emphasized by the pre-emphasis prior to transmission are attenuated upon reception to thereby resume the flat frequency-to-gain characteristic. Also, the noises which are liable to occur relatively more on the higher frequency side are suppressed by the de-emphasis characteristic upon reception.

When a bandpass filter is used instead of the noise canceller IC for the above-described noise cancel section 18a, that bandpass filter should preferably have such bandpass characteristic that the central frequency portion (around 1 kHz) of the speech signal is mainly passed while the lower-frequency and higher-frequency portions are attenuated as shown in Fig. 5 at c.

The operation of the radio receiver will now be described.

The radio wave received by the antenna 10 is sent as an RF signal to the receiving section 12 in where it is mixed with a local oscillation signal supplied from the modulation/PLL/oscillation section 4 and converted into an IF signal having a predetermined intermediate frequency.

This IF signal is amplified in the receiving section 12 with its amplitude being limited. The IF signal is then subjected to an FM detection in the detection/demodulation section 13 to demodulate it into the low-frequency signal.

At this time, the noise amplifying/rectifying section 14 amplifies and rectifies the ultra high frequency noise components of the low-frequency signal contained in the detection output to thereby generate a voltage corresponding to the amplitude of the ultra high frequency noise components, which voltage is applied to the control section 1.

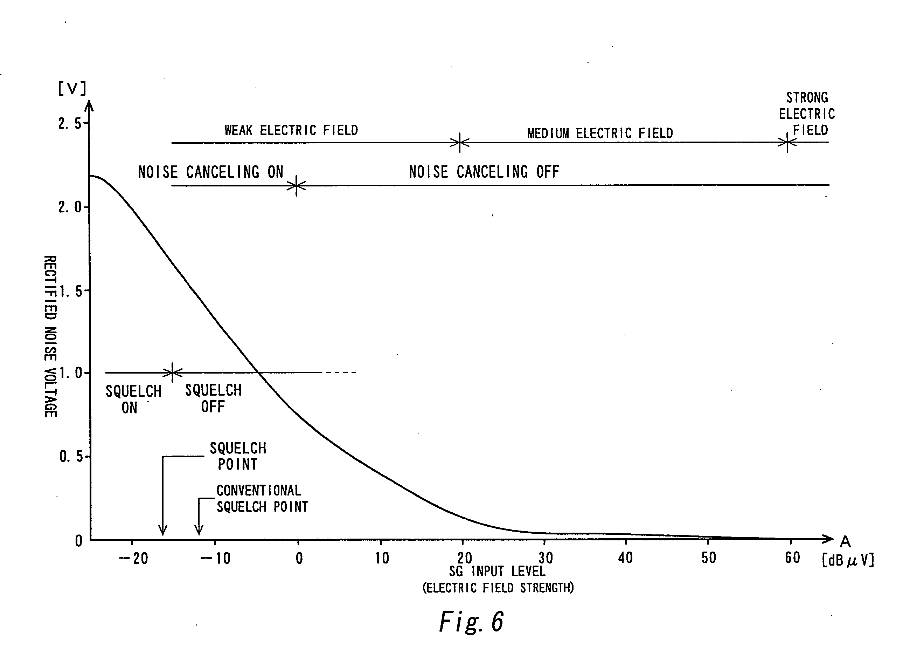

In this case, the voltage corresponding to the amplitude of the ultra high frequency noise components (i.e., the noise voltage after rectification) exhibits such a characteristic which is inversely proportional, as shown in Fig. 6, to the electric field strength below a certain level (i.e., the electric field strength within the low electric field range).

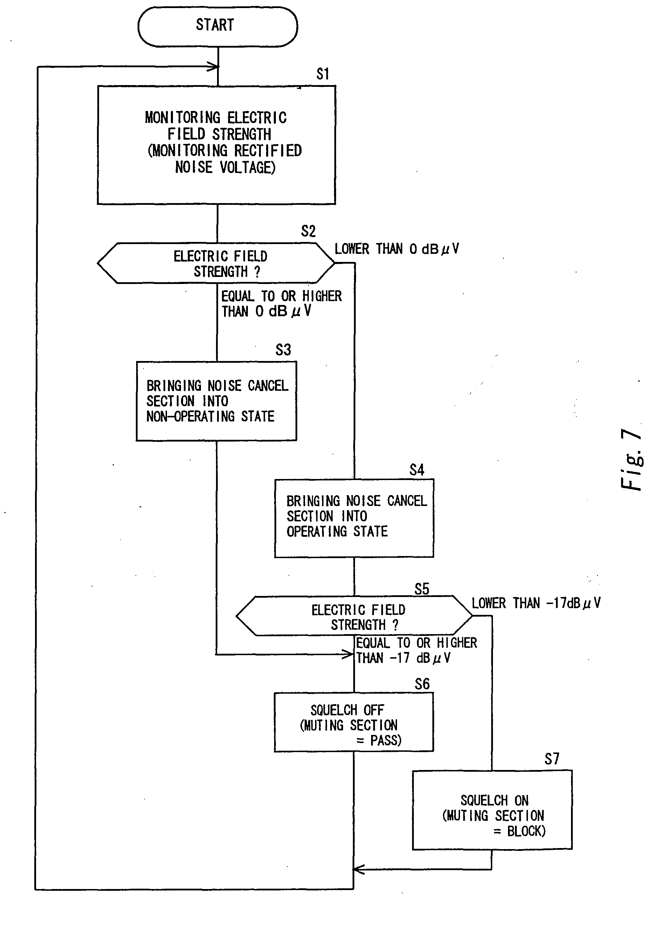

Therefore, monitoring the rectified noise voltage by the control section 1 is equivalent to monitoring the electric field strength (refer to steps S1, S2 and S5 in Fig. 7).

In this embodiment, when the electric field strength reaches a first level the above-described noise canceling means 18 is brought into an operating state by the control section 1. The following description will be made assuming that this first level of the electric field strength is 0 dBµV.

In this embodiment, a control is further made by the above-described control section 1 in such a way that when the electric field strength reaches a second level which is lower than the above-mentioned first level the output of the low-frequency signal is blocked by the audio muting section 19. In the following description, it is assumed that this second level is -17 dBµV.

The numerical values for the first and second levels have been stored in the memory 2, so that the control section 1 can refer to these values in the memory as occasion demands.

Based on the monitoring of the rectified noise voltage by the control section 1, when it is determined that the electric field strength is equal to or higher than 0 dBµV (corresponding to "equal to or higher than 0 dBµV" at step S2 of Fig. 7), the analog switch-A 17a is rendered on and the analog switch-B 17b is rendered off by the control section 1, as a result of which the noise cancel section 18a is brought into the non-operating (off) state (see step S3 of Fig. 7).

A further control is made by the control section 1 so that the audio muting section 19 is brought into a pass state (i.e., a state in which the squelch is off) as shown in Fig. 7 at step S6.

This condition that the electric field strength is equal to or higher than 0 dBµV means such an electric field strength which is above the low electric field range and at which there is not much noise included in the demodulated low-frequency signal.

As a result of the above-described operation of the switch section 17 and the audio muting section 19 under the control of the control section 1, the low-frequency signal from the detection/demodulation section 13 passes through the analog switch-A 17a and the audio muting section 19 after the attenuation of its higher frequency components, which have been emphasized by the pre-emphasis prior to transmission, by the de-emphasis section 16 to resume its flat frequency-to-gain characteristic. After that, the low-frequency signal is amplified by the power amplifier 20 to a certain level and outputted from the speaker 21 as a speech sound.

When it is determined based on the monitoring of the rectified noise voltage by the control section 1 that the electric field strength is lower than 0 dBµV (corresponding to "lower than 0 dBµV" at step S2 of Fig. 7), the analog switch-A 17a is rendered off and at the same time the analog switch-B 17b is rendered on by the control section 1, whereupon the noise cancel section 18a is brought into an operating (on) state (see step S4 of Fig. 7).

This condition that the electric field strength is lower than 0 dBµV means such an electric field strength which is in the weak electric field range and at which noise is included in the demodulated low-frequency signal to a certain extent.

Subsequently, it is determined by the control section 1 based on the monitoring of the rectified noise voltage whether or not the electric field strength is in the range lower than 0 dBµV and, in addition, in the range lower than -17 dBµV (step S5 of Fig. 7).

When it is determined that the electric field strength is in the range from 0 dBµV to -17 dBµV (corresponding to "equal to or higher than -17 dBµV" at step S5 of Fig. 7), the audio muting section 19 is brought into the pass state (the state in which the squelch is off) by the control section 1 (step S6 of Fig. 7).

As a result, the low-frequency signal from the detection/demodulation section 13 is sent, after the attenuation of its higher frequency components which have been emphasized by the pre-emphasis prior to transmission by the de-emphasis section 16 to resume its flat frequency-to-gain characteristic, through the analog switch-B 17b to the noise cancel section 18a in which the noise components are reduced from the low-frequency signal.

As a result of the operation of the switch section 17, the noise canceling means 18 and the audio muting section 19 under the control of the control section 1, the low-frequency signal, which would originally contain noise when demodulated in the low electric field condition, has now effectively reduced its noise components by virtue of the noise cancel section 18a.

The low-frequency signal from which the noise components have thus been removed resumes its flat frequency-to-gain characteristic at the frequency characteristic correction section 18b and passes through the audio muting section 19. Then, the low-frequency signal is amplified by the power amplifier 20 to a certain level and outputted from the speaker 21 as a speech sound.

When it is determined that the electric field strength is lower than -17 dBµV (corresponding to "lower than -17 dBµV" at step S5 of Fig. 7), the audio muting section 19 is brought into the block state (the state in which the squelch is on) by the control section 1 (step S7 of Fig. 7).

This condition that the electric field strength is lower than -17 dBµV means such a very low electric field strength at which it is difficult to recognize a speech sound from the demodulated low-frequency signal.

In this condition, the low-frequency signal does not pass through the audio muting section 19, with the result that no speech sound is outputted from the speaker 21.

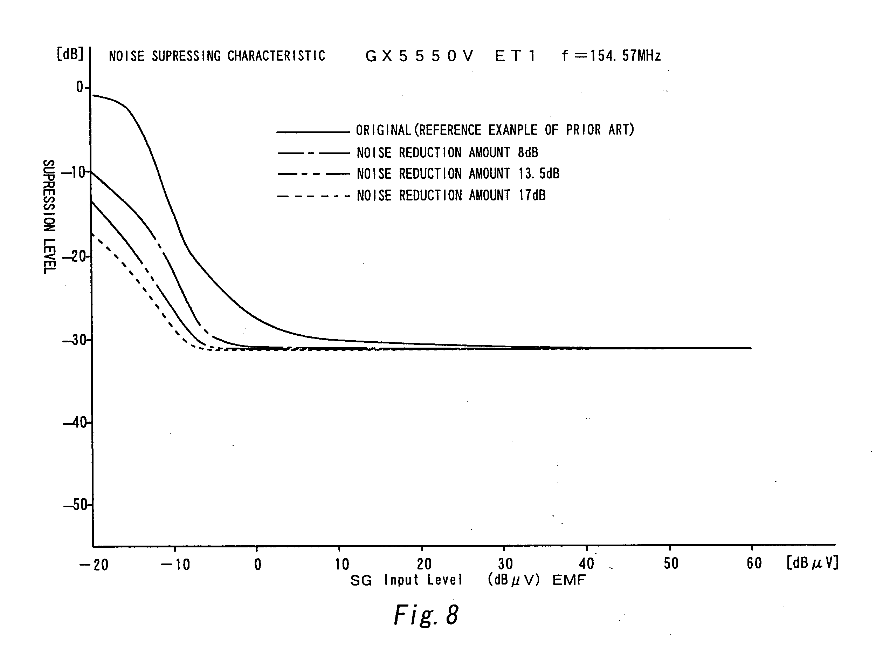

Fig. 8 shows a specific noise suppressing characteristic of the radio receiver.

First, the radio receiver is put in such a condition that no desired receiving signal is present and that the low-frequency signal from the de-emphasis section 16 is not allowed to pass the noise cancel section 18a, i.e., the low-frequency signal is not sent to the noise cancel section 18a but is sent through the switch section 17 to the audio muting section 18 to thereby cause the low-frequency signal (noise) to be outputted. This output level is determined as a reference level (0 dB).

Next, an unmodulated receiving signal generated by a high-frequency signal generator is supplied to the radio receiver, and it is observed how much in output level the low-frequency signal (noise) is suppressed with respect to the above-described reference level, the results of which are plotted.

The characteristic obtained here is meaningful as one for prior art and therefore represents values of a comparison group.

On the other hand, while maintaining the above-described reference level as it is, the low-frequency signal from the de-emphasis section 16 is passed through the noise cancel section 18a (i.e., sent to the noise canceling means 18) to cause the low-frequency signal (noise) to be outputted through the audio muting section 19.

Subsequently, an unmodulated receiving signal generated by a high-frequency signal generator is applied to the radio receiver, and it is observed how much in output level the low-frequency signal (noise) is suppressed with respect to the above-described reference level, the results of which are then plotted.

The characteristic obtained here represents values of an experimental group.

In the case of such characteristics, in general, the receiving signal level at which the noise is suppressed by 20 dB is defined as the receiving sensitivity (20dB QS (Quieting Sensitivity)).

Herein, comparison is made between the prior art and the embodiment of the present invention in relation to the results of the experiments conducted using radio receivers of 150 MHz band having an identical structure.

In the case of the low-frequency signal which does not pass through the noise cancel section 18a, i.e., the low-frequency signal in the conventional radio receiver having no noise cancel section (a reference example), the 20dB QS was -8.0 dBµV.

On the other hand, in the case of the low-frequency signal of the embodiment of the present invention which is caused to pass through the noise cancel section 18a in a low electric field condition, the 20dB QS was - 11.0 dBµV when the noise reduction amount at the noise cancel section 18a was -8 dB.

It was thus appreciated that the receiving sensitivity was improved by about 3.0 dB in the embodiment of the invention (an experimental example) as compared to the prior art (the reference example).

Also, when the noise reduction amount at the noise cancel section 18a was -13.5 dB, the 20dB QS was -14.0 dBµV from which it was appreciated that the receiving sensitivity was improved by about 6.0 dB in the embodiment of the invention as compared to the prior art.

Furthermore, when the noise reduction amount at the noise cancel section 18a was -17 dB, the 20dB QS was -16.0 dBµV from which it was appreciated that the receiving sensitivity was improved by about 8.0 dB in the embodiment of the invention as compared to the prior art.

By providing the noise canceling means 18 as described above, it became possible to set the point at which the squelch is rendered on to an electric field strength which is further lower than the conventional squelch point.

As a result, it became possible to realize an enhancement of receiving sensitivity, i.e., an extension of the communication area.

Although description has been made as to the case where the noise cancel section 18a is set to have a predetermined amount of noise reduction in the above embodiment, it may be possible to change over the noise reduction amount in accordance with the value of electric field strength.

More specifically, such an arrangement is made that the amount of noise reduction can be controlled by the control section 1 for the noise cancel section 18a.

In this case, it may be possible for the control section 1 to change over the noise reduction amount in the increasing direction (8 dB → 13.5 dB → 17 dB) as the electric field strength of the received radio wave drops.

As described above, by changing over in accordance with the control signal from the control section 1 the operating/non-operating state of the noise canceling means 18 and the noise reduction amount of the noise cancel section with the decrease of the electric field by the selective use of the noise cancel section 18a, it becomes possible to maintain the clearness of the low-frequency signal in a medium or a high electric field strength condition and to effectively reduce noise components as the electric field strength becomes lower.

As a result, it will be possible improve the rate of mixing of noise of a low-frequency signal in a low electric field strength condition and to enhance the receiving sensitivity of a radio receiver.

The above-described embodiment of the invention has such a construction that it is possible to selectively switch the operating/non-operating state and the noise reduction amount of the noise cancel section 18a by the control section 1.

For the case of using for a long period of time in an environment where the radio waves received has a low electric field,. such an construction may also be possible that the control section 1 is added with a change-over switch means which enables the user to maintain the noise cancel section 18a always in the operating state and to select its noise reduction amount.

In the case where the bandpass filter is used instead of the noise cancel section 18a, when it is determined based on the monitoring of the rectified noise voltage by the control section 1 that the electric field strength is within the range lower than 0 dBµV, the bandpass filter is brought into an operating (on) state.

In this case, the low-frequency signal from the detection/demodulation section 13 is attenuated in its higher frequency component range, which have been emphasized by the pre-emphasis prior to transmission, by the de-emphasis section 16 to resume the flat frequency-to-gain characteristic, and further attenuated in its lower frequency and higher frequency ranges by the bandpass filter. As a result, even when the electric field strength is very low and noise is included in the demodulated low-frequency signal, the noise components are effectively removed. The low-frequency signal from which the noise components have thus been removed is then passed through the audio muting section 19, amplified by the power amplifier 20 to a certain level and outputted from the speaker 21 as a speech sound.

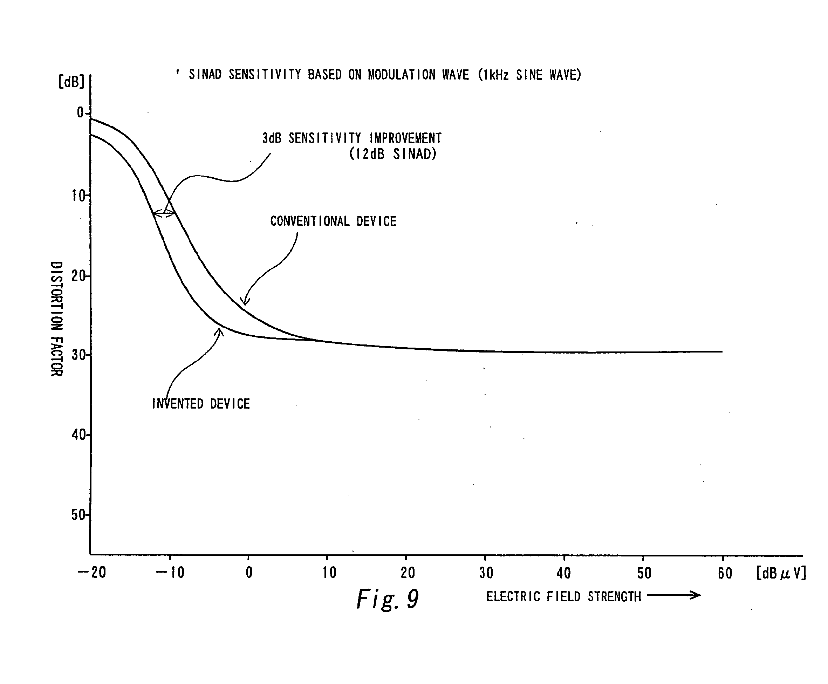

Fig. 9 shows a comparison of the relations between the electric field strength and the distortion factor when a signal modulated with a 1 kHz sine wave was generated by a signal generator for a radio receiver according to the embodiment of the invention and a conventional radio receiver having the same structure except for the bandpass filter.

It was appreciated that the radio receiver according to the embodiment of the invention was improved by about 3 dB as compared to the conventional radio receiver when the distortion factor was 12 dB (25%) for example.

More specifically, with the conventional radio receiver having no bandpass filter, the SINAD (Signal to Noise And Distortion) sensitivity at which a distortion factor of 12 dB was obtained was -9.5 dBµV. With radio receiver according to the present embodiment in which the bandpass filter is rendered effective in the low electric field strength range, however, the noise components were removed even at the input level of -9.5 dBµV, as a result of which the distortion factor was improved to 18 dB. Consequently, the SINAD sensitivity at which a distortion factor of 12 dB was obtained was improved by 3 dB, as compared to the conventional one, to -12.5 dBµV.

By virtue of the above fact, the point at which the squelch is rendered on can be set to an electric field strength which is lower than the conventional one. As a result, it will become possible to realize a high sensitivity (an extension of communication distance).

In the above-described embodiment, the bandpass filter has a predetermined bandpass characteristic. However, the bandpass filter can also be constructed in such a way that it is switched among a plurality of characteristics in accordance with the value of electric field strength.

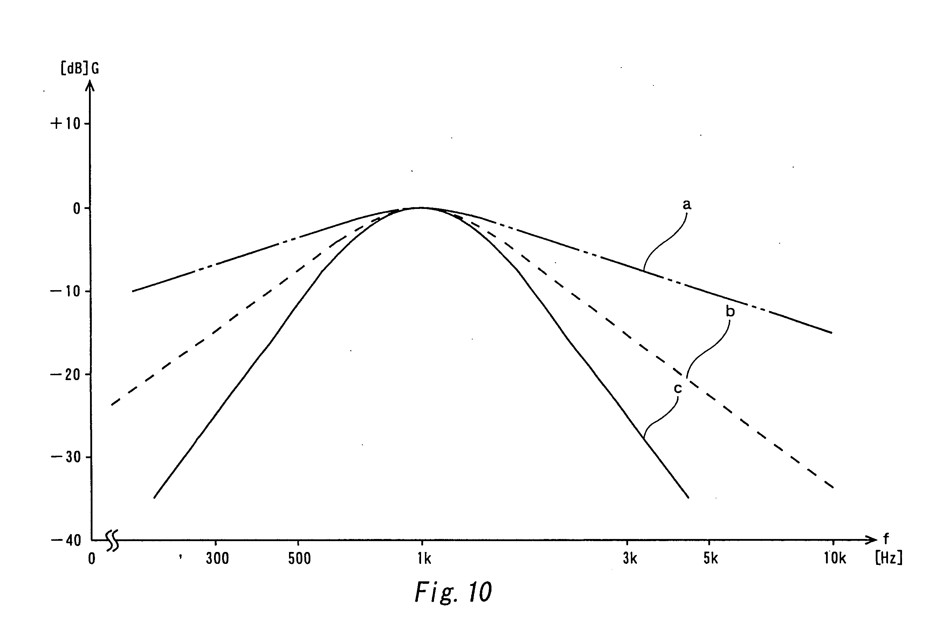

More specifically, such an arrangement is made for the bandpass filter that its frequency band for allowing the low-frequency signal to pass can be switched in a plurality of steps (see Fig. 10). In this case, the control section 1 can perform, for example, such a switching that the frequency band is made narrower (a → b → c in Fig. 10) as the electric field strength of the received radio wave drops.

By making the pass frequency band of the bandpass filter narrower with the decrease of the electric field in this manner, it becomes possible to remove noise more effectively as the electric field becomes weaker without degrading the clearness of the low-frequency signal in a medium or a high electric field strength condition. Consequently, it is possible to enhance the receiving sensitivity of the radio receiver by improving the distortion factor of the low-frequency signal in a low electric field strength condition.

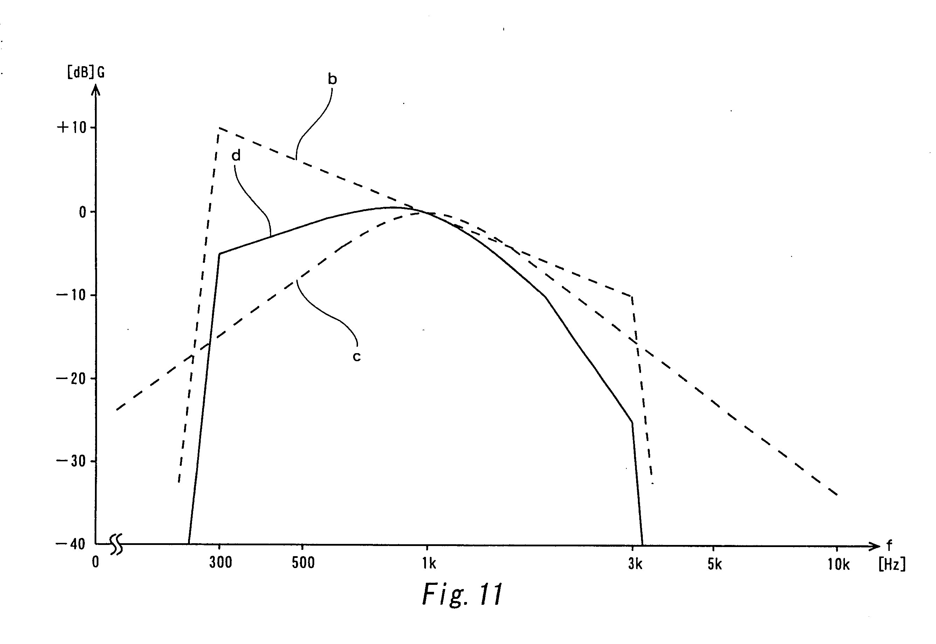

In the above-described circuit of Fig. 4, a filter for realizing the de-emphasis in the de-emphasis section 16 (b in Fig. 11 and b in Fig. 5) and the bandpass filter (c in Fig. 11 and c in Fig. 5) perform respective equalizing processings independently from each other. These equalizing processings performed by the separate filters can be realized by a single filter having a combined characteristic (d in Fig. 11).

For example, the de-emphasis section 16 is constructed so as to be switched among a plurality of characteristics. The de-emphasis section 16 carries out a de-emphasis in accordance with the characteristic b of Fig. 11 in the normal condition, whereas it carries out a de-emphasis in accordance with the characteristic d of Fig. 11 in which the bandpass characteristic has been included, when removing noise components of the low-frequency signal in a low electric field strength condition. With such arrangement, it becomes possible to enhance the receiving sensitivity by removing noise components in a low electric field strength condition while decreasing the number of parts used.

In the above-described embodiment of the present invention, it is constructed such that the bandpass filter is selectively switched into the operating/non-operating state by the control section 1. For the case of using it for a long period of time in an environment where the electric field strength of the radio waves received is low, however, such an construction may also be possible that the control section 1 is added with a change-over switch means which enables the user to maintain the bandpass filter always in the operating state.

As described above, with the radio receiver according to the present invention the following advantageous effects can be obtained.

In the radio receiver according to the invention described above, the noise cancel section is brought into the operating state when the electric field strength of the received radio wave is low, so that noise components of the low-frequency signal can be reduced by passing the low-frequency signal through the noise cancel section in a low electric field strength condition, while in a medium or a high electric field strength condition the noise cancel section is rendered non-operative (non-passable), so that the clearness of the low-frequency signal is maintained.

Consequently, it becomes possible to improve the rate of noise mixing of the low-frequency signal in a low electric field strength condition to thereby enhance the receiving sensitivity of a radio receiver.

In a radio receiver according to the present invention, the noise cancel section becomes operative when the electric field strength reaches the first level, whereas when the electric field strength reaches the second level lower than the first level the output of the low-frequency signal is blocked by the audio muting section. Therefore, in a medium or a high electric field strength condition, the clearness of the low-frequency signal is maintained as a result that the noise cancel section is in the non-operating state, while in a low electric field strength condition noise components contained in the low-frequency signal is reduced as a result that the noise cancel section is in the operating state. In a further lower electric field strength condition, the output of the low-frequency signal is blocked by the audio muting section.

As a result, it becomes possible to improve the rate of noise mixing of the low-frequency signal in a low electric field strength condition to thereby enhance the receiving sensitivity of the radio receiver.

In a radio receiver according to the present invention, when the electric field strength of the received radio wave is low, the noise cancel section is rendered operative to reduce noise components contained in the low-frequency signal, wherein the amount of reduction of noise is increased as the electric field becomes weaker. Therefore, it will become possible to reduce noise components more effectively as the electric field becomes weaker while maintaining the clearness of the low-frequency signal in a medium and a high electric field strength condition.

As a result, it becomes possible to improve the rate of noise mixing of the low-frequency signal in a low electric field strength condition to thereby enhance the receiving sensitivity of the radio receiver.

In a radio receiver according to the present invention, in addition to the above-described operations, the control section operates such that when the electric-field strength of the received radio waves is low the bandpass filter for allowing a predetermined band of frequency components of the low-frequency signal to pass is selected and brought into an operating state. Therefore, in the case of a low electric-field strength condition noise components of the low-frequency signal are eliminated by means of the functioning of the bandpass filter, while in a medium or a high electric-field strength condition the bandpass filter is practically in a non-operative condition, so that clearness of the low frequency signal will not be degraded. Thus, it becomes possible to improve the distortion factor of the low-frequency signal around its central frequency to thereby increase the reception sensitivity of the radio receiver.

In a radio receiver according to the present invention, in addition to the above-described operations, the control section operates such that, when the electric-field strength of the received radio waves is low, the bandpass filter for passing the low-frequency signal within the predetermined frequency band is selected to be put into an operating state to thereby remove the noise components of the low-frequency signal, wherein the pass frequency band of the bandpass filter is made narrower as the electric-field strength becomes lower. It thus becomes possible to remove the noise components more effectively as the electric-field strength becomes lower without degrading clearness of the low-frequency signal in a medium and a high electric-field strength condition. Consequently, it will be possible to improve the distortion factor of the low-frequency signal to thereby increase the reception sensitivity of the radio receiver in a low electric-field strength condition.

According to a communication system which is for wireless communication between ends and provided on at least one of the ends with the above described speech input system and radio receiver, it becomes possible to well remove noise regardless of directions of the sources of the objective sound and the noise, regardless of the difference in level between the objective sound and the noise and/or regardless of whether the noise abruptly changes its tone or volume, and to achieve a clear speech input even in such a condition that there is environmental noise and/or sound from a speaker.

In the radio receiver of the above structure, when the electric field strength of the received radio waves is low, the control section operates and brings the noise canceling means for reducing noise of the low-frequency signal into an operating state. Therefore, the noise components of the low-frequency signal can be reduced by the operation of the noise canceling means in a low electric-field strength condition. On the other hand, in a medium or a high electric-field strength condition the noise canceling means is in a non-operating state in substance, so that the clearness of the low-frequency signal (speech sound) will not be worsened. Consequently, it will become possible to improve the reception sensitivity of a radio receiver by the reduction of noise components of the low-frequency signal in a low electric-field strength condition and at the same time to prevent the clearness of the low-frequency signal from being worsened in a medium or a high electric-field strength condition.

## Claims

1. A system for inputting speech comprising:
an echo canceller section for subtracting a pseudo echo signal generated by an adaptive filter based on a speech signal inputted to a first input terminal from a speech signal for sending inputted to a second input terminal to thereby remove echo components contained in said speech signal for sending;
a main microphone for mainly receiving sound from an objective sound source;
a reference microphone disposed a predetermined distance apart from the main microphone for mainly receiving sounds from other than said objective sound source; and
an audio delay section for giving a predetermine delay to said speech signal for sending received from said main microphone;
wherein the speech signal from said reference microphone is inputted to the first input terminal of said echo canceller section, while said speech signal for sending which is from said main microphone and to which said delay has been given in said audio delay section is inputted to the second input terminal of said echo canceller section; and
wherein the delay given at said audio delay section is adjusted within a range of delay time of echo components which are removed by the echo canceller section.

2. A system for inputting speech comprising:
an echo canceller section for subtracting a pseudo echo signal generated by an adaptive filter based on a speech signal inputted to a first input terminal from a speech signal for sending inputted to a second input terminal to thereby remove echo components contained in the speech signal for sending;
a main microphone for mainly receiving sound from an objective sound source;
a reference microphone disposed a predetermined distance apart from said main microphone for mainly receiving sounds from other than said objective sound source;
an audio delay section for giving a predetermine delay to said speech signal for sending received from the main microphone;
an interface for receiving a reception signal from an external system and for sending said speech signal for sending which has been processed by said echo canceller section to the external system; and
a speaker for outputting the reception signal obtained through said interface as an audio sound;
wherein the speech signal from said reference microphone is inputted to the first input terminal of said echo canceller section, while said speech signal for sending which is from said main microphone and to which said delay has been given in said audio delay section is inputted to the second input terminal of said echo canceller section; and
wherein the delay given at said audio delay section is adjusted within a range of delay time of echo components which are removed by said echo canceller section.

3. A system for inputting speech according to claim 1 or claim 2, wherein each of said main microphone and said reference microphone is constructed so as to collect sounds in a desired manner with the aid of a respective shielding member.

4. A system for inputting speech according to claim 1 or claim 2, wherein each of said main microphone and said reference microphone is constructed so as to collect sounds in a desired manner by its directivity.

5. A system for inputting speech according to claim 1 or claim 2, wherein each of said main microphone and said reference microphone is constructed so as to collect sounds in a desired manner by means of a combination of its directivity and a shielding member.

6. A radio receiver for receiving broadcasted or transmitted radio waves and detecting therefrom a low-frequency signal comprising:
a receiving section for receiving the broadcasted or transmitted radio waves;
a detection/demodulation section for subjecting a high-frequency signal generated in response to the reception at said receiving section to a detection operation to produce the low-frequency signal;
a noise canceling means for reducing noise components of the low-frequency signal produced by said detection/demodulation section; and
a control section for monitoring an electric-field strength of the received radio waves and controlling based thereon the operation of said noise canceling means;
wherein said control section brings said noise canceling means into an operating state when the electric-field strength of the received radio waves is low.

7. A radio receiver according to claim 6, wherein an audio muting section for blocking an output of said low-frequency signal is further provided, and wherein said control section brings said noise canceling means into the operating state when said electric-field strength reaches a first level and blocks the output of said low-frequency signal by said audio muting section when said electric-field strength reaches a second level which is lower than said first level.

8. A radio receiver according to claim 6 or claim 7, wherein said noise canceling means is capable of switching an amount of reduction of noise in a plurality of steps, and wherein said control section controls the switching in such a manner that the amount of reduction of noise is increased as the electric-field strength of the received radio wave becomes lower.

9. A radio receiver according to any one of claims 6 to 8, wherein said noise canceling means is a bandpass filter for allowing the low-frequency signal within a predetermined frequency band to pass.

10. A radio receiver according to any one of claims 6 to 8, wherein said bandpass filter is capable of switching its frequency band for passing said low-frequency signal therethrough in a plurality of steps, and wherein said control section causes the switching to be performed such that said frequency band is made narrower as the electric-field strength of the received radio waves decreases.

11. A communication system for carrying out communication with or without wire, wherein a system for inputting speech according to any one of claims 1 to 5 is used for a speech input in at least one of those ends of said communication system between which communication is carried out.

12. A communication system for carrying out communication wirelessly, wherein a system for inputting speech according to any one of claims 1 to 5 is used for a speech input in at least one of those ends of the communication system between which communication is carried out, and wherein a radio receiver according to any one of claims 6 to 10 is used in at least one of those end of the communication system between which communication is carried out.
